(19) **Europäisches Patentamt European Patent Office Office européen des brevets**

(11) **EP 1 587 145 B1**

(12) **EUROPÄISCHE PATENTSCHRIFT**

(45) Veröffentlichungstag und Bekanntmachung des Hinweises auf die Patenterteilung:
**18.02.2009   Patentblatt 2009/08**

(51) Int Cl.:
*H01L 27/08* (2006.01)       *H01L 21/02* (2006.01)

(21) Anmeldenummer: **05106669.4**

(22) Anmeldetag: **12.06.2003**

(54) **Satz integrierter Gitterkondensatoren und dessen Herstellungsverfahren**

Set of integrated grid capacitors and method of manufacturing the same

Ensemble d'agencements de condensateurs de grille intégrés et méthode de fabrication correspondante

(84) Benannte Vertragsstaaten:
**DE FR**

(30) Priorität: **08.07.2002   DE 10230697**

(43) Veröffentlichungstag der Anmeldung:
**19.10.2005   Patentblatt 2005/42**

(62) Dokumentnummer(n) der früheren Anmeldung(en) nach Art. 76 EPÜ:
**03762398.0 / 1 520 299**

(73) Patentinhaber: **Infineon Technologies AG**
**81669 München (DE)**

(72) Erfinder:
• **Fischer, Armin**
  **81825, München (DE)**
• **Ungar, Franz**
  **85232, Unterbachern (DE)**

(74) Vertreter: **Karl, Frank et al**
**Kindermann Patentanwälte**
**Postfach 100234**
**85593 Baldham (DE)**

(56) Entgegenhaltungen:
EP-A- 1 111 694         JP-A- 9 007 887
JP-A- 2000 323 664      US-A- 3 766 308
US-A- 5 659 182         US-B1- 6 198 619

**Beschreibung**

Die Erfindung betrifft eine integrierte Gitterkondensatoranordnung, die mindestens einen schaltungstechnisch wirksamen Hauptteil enthält.

Aus einer integrierten Anordnung lassen sich einzelne Bauelemente mechanisch nicht ohne Zerstörung der Bauelemente voneinander trennen. Als Herstellungstechniken für integrierte Anordnungen werden unter anderem Schichtaufbringungsverfahren und Schichtstrukturierungsverfahren eingesetzt.

Ein Kondensator enthält zwei einander gegenüberliegende Elektroden, zwischen denen ein Dielektrikum angeordnet ist. Beispiele für integrierte Kondensatoren sind:

- sogenannte MIM-Kondensatoren (Metall Isolator Metall),
- gestapelte Kondensatoren, die auch als Sand(wich)-Kondensatoren bezeichnet werden, oder
- Gitterkondensatoren, die auch als Grid-Kondensatoren bezeichnet werden.

Eine Kapazität ist schaltungstechnisch wirksam, wenn sie nicht nur parasitär, d.h. eigentlich unerwünscht ist, sondern auch für das Funktionieren der Schaltungsanordnung erforderlich ist. Beispielsweise dienen schaltungstechnisch wirksame Kondensatoren als:

- Block- oder Stützkondensator,
- Teil eines Schwingkreises,
- Ladekondensator, oder
- zum Speichern von digitalen Informationen.

Bei der Herstellung von sogenannten BEOL-Kapazitäten (Back End Of Line) oder von Far-BEOL-Kapazität in integrierter Form kommt es zu erheblichen Streuungen der Kapazitätswerte. Die Streuung entsteht durch Geometrieabweichungen infolge von Prozessinhomogenitäten. Die Streuungen treten innerhalb einer Halbleiterscheibe bzw. eines Wafers, innerhalb eines Fertigungsloses sowie auch zwischen verschiedenen Fertigungslosen auf. Liegt der Kapazitätswert eines Kondensators außerhalb der vorgegebenen Spezifikationsgrenzen, so kommt es zu einem sogenannten Performance-Verlust oder sogar zu einem Ausbeuteverlust des entsprechenden integrierten Schaltkreises.

Aus der EP 1 111 694 A2 ist ein Bauteil mit Dünnschichtschaltkreis und trimmbarem Kondensator bekannt. Eine Bodenelektrode des Kondensators hat eine strukturierte Fläche mit Schlitzen die fingerförmige Abschnitte begrenzen. Die fingerförmigen Abschnitte können mittels Laser abgetrennt werden. Eine Deckelektrode kann fingerförmigen Abschnitte haben oder ohne fingerförmige Abschnitte hergestellt werden.

Aus der US 3,766,308 ist eine Kondensatoranordnung bekannt, die einen Hauptkondensator und mehrere zuschaltbare Hilfskondensatoren enthält. Aus der US 5,659,182 ist ein Schmelzelement mit drei Anschlüssen bekannt.

Es ist Aufgabe der Erfindung, einen einfach herzustellenden Satz von Gitterkondensatoranordnungen anzugeben, deren Kapazität möglichst nahe an einer vorgegebenen Sollkapazität liegt.

Diese Aufgabe wird durch einen Satz von Kondensatoranordnungen mit den im Patentanspruch 1 angegebenen Merkmalen sowie durch ein zugehöriges Verfahren mit den im Patentanspruch 4 angegebenen Merkmalen gelöst. Weiterbildungen sind in den Unteransprüchen angegeben.

Ein zum besseren Verständnis der Erfindung dienender Satz enthält mindestens zwei integrierten Kondensatoranordnungen, die gemäß gleichen geometrischen Entwürfen bzw. Layouts hergestellt worden sind und die jeweils einen schaltungstechnisch wirksamen Hauptkondensator und mindestens einen Korrekturkondensator enthalten. Die eine Kondensatoranordnung enthält eine elektrisch leitfähige Verbindung zwischen dem Korrekturkondensator und dem Hauptkondensator, wobei die Verbindung nach der Herstellung des Hauptkondensators dieser Kondensatoranordnung hergestellt worden ist. Die andere Kondensatoranordnung enthält eine elektrisch isolierenden Unterbrechung zwischen dem gleichen Korrekturkondensator und dem Hauptkondensator, wobei die Unterbrechung gemäß den geometrischen Entwürfen hergestellt worden ist.

Müssen Korrekturen beispielsweise nur bei 20 Prozent der hergestellten Kondensatoranordnungen durchgeführt werden, um die Sollkapazität zu erreichen, so sinkt der Aufwand erheblich im Vergleich zu einer Korrekturmöglichkeit, bei der die Korrektur nur durch Abtrennen von Kondensatoren ausgeführt werden kann. Bei einer solchen Korrektur wären nämlich in 80 Prozent der Kondensatoranordnungen Kondensatoren lokal abzutrennen.

Die Verbindung wird bei einer Weiterbildung auf einfache Art durch lokales Erhitzen hergestellt, so dass Bauelemente in der Umgebung der Verbindung vor einer erhöhten Wärmebelastung geschützt sind. Außerdem lassen sich durch lokales Erhitzen auf einfache Art dauerhafte Verknüpfungen herstellen. Im Vergleich zum Herstellen von Unterbrechungen durch lokales Erhitzen können Verknüpfungen durch lokales Erhitzen bei niedrigeren Temperaturen durchgeführt werden. Damit ist die thermische Belastung insbesondere bei der Herstellung einer Vielzahl von Verknüpfungen auf einer Halbleiterscheibe gering.

Das lokale Erhitzen wird beispielsweise mit Hilfe eines Laserstrahls durchgeführt. Damit ist eine Möglichkeit gegeben, die Kapazität des schaltungstechnisch wirksamen Hauptkondensators durch eine Parallel- oder Serienschaltung mit den Korrekturkondensatoren zu vergrößern bzw. zu verkleinern. Diese Korrekturmöglichkeit gestattet es, integrierte Kondensatoranordnungen mit vorgegebenen Kapazitätswerten auf einfache Art zu produzieren.

Bei einer Weiterbildung enthält die Verbindung zwei zueinander beabstandete Leitbahnabschnitte, zwischen denen nur ein Dielektrikum angeordnet ist. Die Materialien der Leitbahnabschnitte und des Dielektrikums sind so gewählt, dass beim Erhitzen Materialverwerfungen der Leitbahn entstehen, die das Dielektrikum durchdringen. Beispielsweise lässt sich hier das sonst unerwünschte "Spiking" zum Herstellen einer elektrischen Verbindung nutzen. Bei einer alternativen Ausgestaltung enthält das Dielektrikum Dotieratome, die beim Erhitzen die Leitfähigkeit des Dielektrikums ändern. In diesem Zusammenhang wird auch von einem Aktivieren der Dotieratome gesprochen. Jedoch gibt es auch noch andere Möglichkeiten zur Herstellung der Verbindung, die auch als Antifuse bezeichnet wird.

Bei einer nächsten Weiterbildung enthalten die Schaltungsanordnungen mindestens einen weiteren Korrekturkondensator, der vom Hauptkondensator abgetrennt ist oder zum Hauptkondensator zugeschaltet worden ist.

Die Weiterbildung geht von der Überlegung aus, dass die Kapazitätswerte von eigentlich gleich aufzubauenden integrierten Kondensatoren um einen Sollwert sowohl nach unten als auch nach oben streuen kann. Korrekturen können auf ein Minimum beschränkt werden, wenn es sowohl eine Korrekturmöglichkeit des Kapazitätswertes zu größeren Kapazitätswerten hin als auch eine Korrekturmöglichkeit zu kleineren Kapazitätswerten hingibt. Der weitere Korrekturkondensator bietet im Vergleich zu dem oben genannten Korrekturkondensator bei Parallelschaltung der Kondensatoren diese zweite Korrekturmöglichkeit.

Bei einer Weiterbildung wird eine weitere Unterbrechung zum Abtrennen des weiteren Korrekturkondensators durch lokales Erhitzen hergestellt. Das lokale Erhitzen lässt sich beispielsweise mit Hilfe eines Laserstrahls oder mit Hilfe eines Stromstoßes durch eine Leitbahneinengung durchführen.

Bei einer anderen Weiterbildung werden Dielektrika der Kondensatoren durch ein Dielektrikum zwischen Metallisierungslagen gebildet, in denen Verbindungsabschnitte von Verbindungen zu integrierten Halbleiterbauelementen der integrierten Kondensatoranordnung liegen. Im Bereich des Kondensators lässt sich ein anderes Dielektrikum verwenden als im übrigen Bereich zwischen den Metallisierungslagen, z.B. ein Dielektrikum mit einer höheren Dielektrizitätskonstante. Beispiele für solche Kondensatoren sind gestapelte Kondensatoren oder Gitterkondensatoren. Mit anderen Worten liegen die Elektroden eines Kondensators in mehr als zwei Metallisierungslagen. Bei solchen Kondensatoren werden bei einer Ausgestaltung nicht nur Elektroden in der obersten Metallisierungslage sondern auch Elektroden in unteren Metallisierungslagen bei der Korrektur schaltungstechnisch abgetrennt oder schaltungstechnisch hinzugefügt. Die Verknüpfungselemente und Unterbrechungen für die unteren Elektroden liegen entweder in der unteren Metallisierungslage, so dass bspw. entsprechend tiefe Aussparungen für einen Laserstrahl vorzusehen sind, oder in einer oberen Metallisierungslage, zu der Verbindungen von der unteren Metallisierungslage führen.

Bei einer anderen Weiterbildung haben Dielektrika der Kondensatoren eine Dicke, die wesentlich kleiner als die Dicke des Dielektrikums zwischen Metallisierungslagen ist. Beispiele für solche Kondensatoren sind MIM-Kondensatoren. Mit anderen Worten liegt mindestens eine Elektrode des Kondensators außerhalb einer Metallisierungslage.

Bei einer nächsten Weiterbildung beträgt die Kapazität eines Korrekturkondensators weniger als 1/3, weniger als 1/10, weniger als 1/100 oder weniger als 1/1000 der Kapazität eines Hauptkondensators. Durch diese Maßnahme wird erreicht, dass eine Feintrimmung möglich ist. So lassen sich mit Korrekturmöglichkeiten im Promille-Bereich die Kapazitätswerte zweier Kondensatoranordnungen derselben integrierten Schaltungsanordnung sehr genau aufeinander abstimmen. Dies ist für einige Anwendungsfälle zwingend erforderlich.

Die Erfindung betrifft einen Satz Gitterkondensatoren mit Korrekturquerelektroden. Auch einzelne Querelektroden der Gitterkondensatoren bieten eine Möglichkeit für eine Korrektur der Kapazität bei der Herstellung. Die oben genannten technischen Wirkungen gelten deshalb insbesondere für die Gitterkondensatoren.

Im Folgenden werden Ausführungsbeispiele der Erfindung an Hand der beiliegenden Zeichnungen erläutert. Darin zeigen:

Figur 1 eine Draufsicht auf eine MIM-Kondensatoranordnung,

Figur 2 eine Draufsicht auf eine Gitterkondensatoranordnung,

Figur 3 eine Querelektrode eines Gitterkondensators mit zwei Unterbrechungsmöglichkeiten,

Figur 4 eine Querelektrode eines Gitterkondensators mit einer kontinuierlichen Unterbrechungsmöglichkeit, und

Figur 5 Verfahrensschritte zum Korrigieren der Kapazität eines integrierten Kondensators.

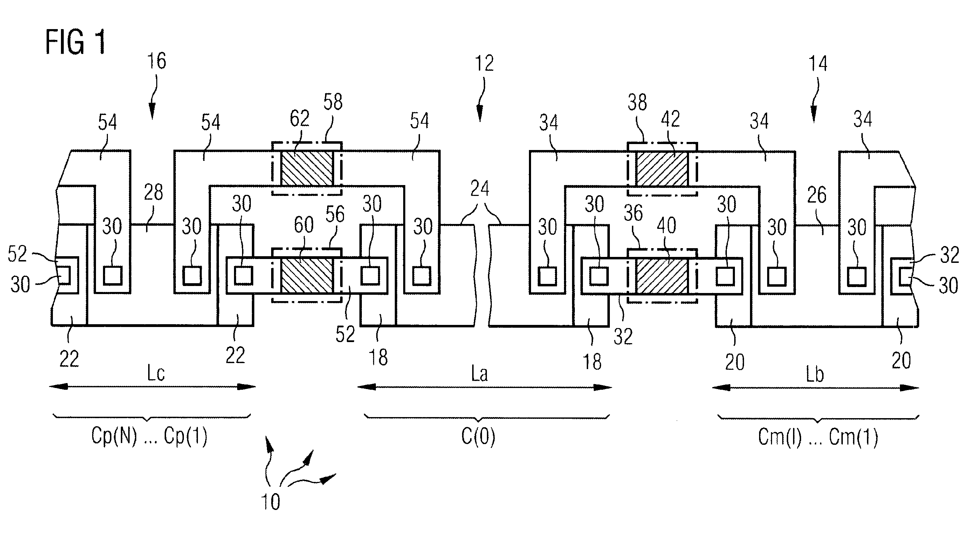

Figur 1 zeigt eine Draufsicht auf eine MIM-Kondensatoranordnung 10, die einen mit einer elektronischen Schaltung verbundenen Hauptkondensator 12 und mehrere rechts vom Hauptkondensator 12 liegende abtrennbare Kondensatoren enthält, von denen nur ein abtrennbarer Kondensator 14 dargestellt ist. Das Dielektrikum ist in Figur 1 aus Gründen der besseren Übersichtlichkeit nicht dargestellt.

In der Kondensatoranordnung 10 liegen links vom Hauptkondensator 12 mehrere zuschaltbare Kondensatoren, von denen in Figur 1 ein zuschaltbarer Kondensator 16 dargestellt ist. Die Kondensatoren 12 bis 16 sind bis auf ihre Längsabmessungen gleich aufgebaut. Die Kondensatoren 12, 14 und 16 enthalten jeweils eine substratnahe Bodenelektrode 18, 20 bzw. 22 und eine substratferne Elektrode 24, 26 bzw. 28. Die Bodenelektroden 18, 20 bzw. 22 sind länger als die jeweils zugehörige substratferne Elektrode 24, 26 bzw. 28 und ragen in Längsrichtung beidseitig über die substratferne Elektrode 24, 26 bzw. 28 hinaus, so dass an den substratnahen Bodenelektroden 18, 20 bzw. 22 Anschlussbereiche für vertikal verlaufende Kontakte 30 entstehen.

Der Hauptkondensator 12 und die abtrennbaren Kondensatoren 14 sind durch Leitbahnen 32 zwischen den Bodenelektroden 18, 20 und durch Leitbahnen 34 zwischen den substratfernen Elektroden 24, 26 elektrisch parallel geschaltet. Geometrisch gesehen sind die abtrennbaren Kondensatoren 14 aber in einer Reihe hintereinander angeordnet. Die Leitbahnen 32 und 34 liegen in einer oberen Metallisierungslage. Zu jeder Leitbahn 32 bzw. 34 führt eine Aussparung 36 bzw. 38 in einem nicht dargestellten Isoliermaterial, das die Leitbahnen 32 und 34 bedeckt. Durch die Aussparungen 36 bzw. 38 lassen sich bei einer Korrektur der Kapazität des Hauptkondensators 12 Bereiche 40 bzw. 42 einer Leitbahn 32 bzw. 34 mit Hilfe eines Laserstrahls verdampfen, so dass eine Unterbrechung entsteht.

Andererseits sind die zuschaltbaren Kondensatoren 16 mit Hilfe von Leitbahnen 52 zwischen den Bodenelektroden 18, 22 bzw. Leitbahnen 54 zwischen den substratfernen Elektroden 24, 28 zum Hauptkondensator 12 elektrisch parallel schaltbar. Geometrisch sind die zuschaltbaren Kondensatoren 16 aber in einer Reihe angeordnet. Auch die Leitbahnen 52 und 54 liegen in einer oberen Metallisierungslage.

Aussparungen 56 bzw. 58 führen durch ein nicht dargestelltes Isoliermaterial bis zu Verknüpfungsbereichen 60 bzw. 62 der Leitbahnen 52 bzw. 54. Die Verknüpfungsbereiche 60, 62 bilden sogenannte Antifuses, d.h. eine Verbindungsmöglichkeit, die beim Auftreffen eines Laserstrahls eine dauerhafte elektrisch leitende Verbindung zwischen den Abschnitten der Leitbahn 52 bzw. einer Leitbahn 54 bildet.

Der Hauptkondensator 12 hat in Längsrichtung der Kondensatoranordnung 10 eine Länge La, die größer als Längen Lb der abtrennbaren Kondensatoren 14 bzw. als Längen Lc der zuschaltbaren Kondensatoren 16 ist. Damit ist auch eine Kapazität C(0) des Hauptkondensators 12 größer als eine Kapazität Cm(I) des Kondensators 14. Dabei ist I eine natürliche Zahl zur Bezeichnung des letzten abtrennbaren Kondensators 14. Die nicht dargestellten abtrennbaren Kondensatoren haben Kapazitäten Cm(1) bis Cm(I-1), die im erläuterten Ausführungsbeispiel gleich der Kapazität Cm(I) sind.

Die Kapazität C(0) des Hauptkondensators 12 ist ebenfalls größer als die Kapazität Cp(1) des zuschaltbaren Kondensators 16. Die in Figur 1 nicht dargestellten zuschaltbaren Kondensatoren haben Kapazitäten Cp(2) bis Cp(N), die gleich der Kapazität Cp(1) bzw. Cm(I) sind. Dabei ist N eine natürliche Zahl zur Bezeichnung des letzten zuschaltbaren Kondensators.

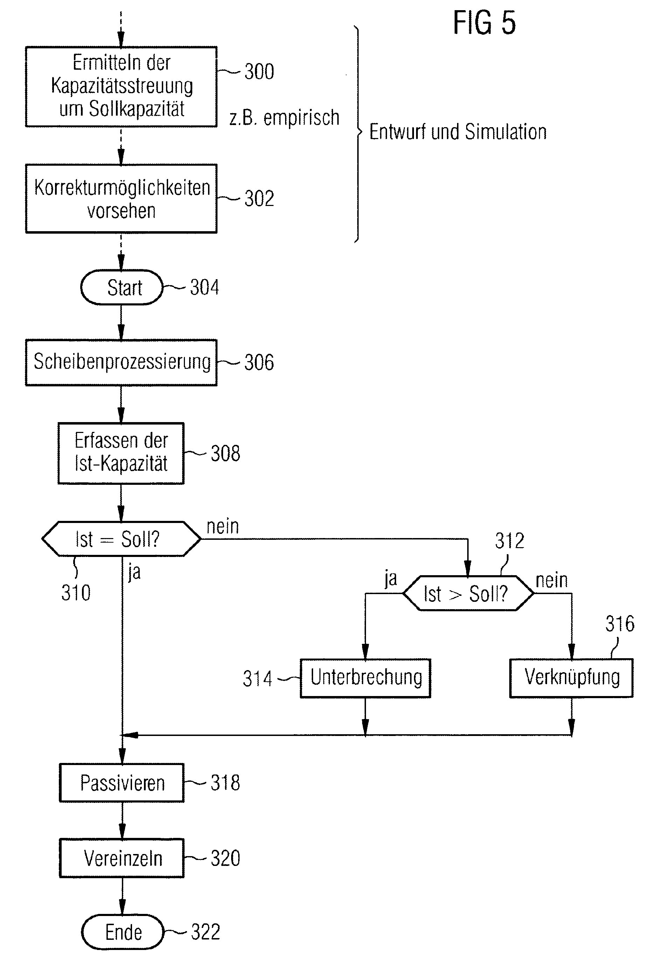

Die Korrektur der Kapazität der Kondensatoranordnung 10 wird unten an Hand der Figur 5 näher erläutert.

Bei einem anderen Ausführungsbeispiel gibt es rechts bzw. links des Hauptkondensators 12 nur einen abtrennbaren Kondensator 14 bzw. einen zuschaltbaren Kondensator 16. Bei einem nächsten Ausführungsbeispiel gibt es neben dem Hauptkondensator 12 nur einen oder mehrere zuschaltbare Kondensatoren 16 bzw. nur einen oder mehrere abschaltbare Kondensatoren 14. Bei einem nächsten Ausführungsbeispiel sind die Kapazitäten Cm(1) bis Cm(I) der Kondensatoranordnung 10 voneinander verschieden. Auch die Kapazitäten Cp(1) bis Cp(N) der Kondensatoranordnung 10 lassen sich voneinander verschieden ausbilden.

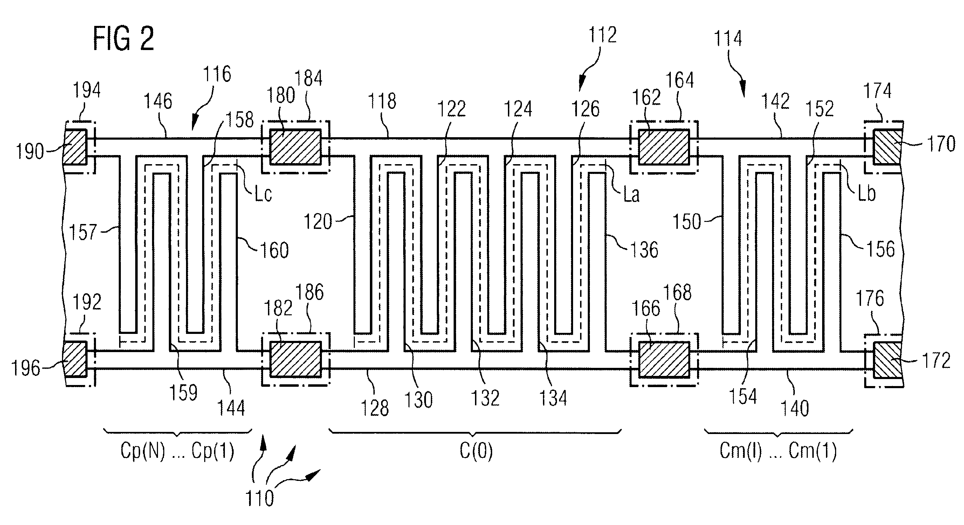

Figur 2 zeigt eine Draufsicht auf eine Gitterkondensatoranordnung 110, die einen mit einer Schaltung verbundenen Hauptkondensator 112 und mehrere abtrennbare Kondensatoren enthält, von denen in Figur 2 ein Kondensator 114 dargestellt ist. Weiterhin enthält die Gitterkondensatoranordnung 110 mehrere zuschaltbare Kondensatoren, von denen in Figur 2 ein Kondensator 116 dargestellt ist. In Figur 2 werden nur die obere Elektrode des Hauptkondensators 112, bzw. des Kondensators 114 bzw. des Kondensators 116 dargestellt. In den darunter liegenden Metallisierungslagen gibt es weitere Elektroden, die den gleichen Verlauf wie die oberen Elektroden haben. Bei einem ersten Ausführungsbeispiel sind die in den verschiedenen Metallisierungslagen liegenden Elektroden eines Kondensators 112, 114 bzw. 116 untereinander jeweils durch mindestens einen vertikalen Kontakt verbunden. Leitbahnen zwischen Kondensatoren 112, 114 und 116 liegen nur in der oberen Metallisierungslage.

Der Hauptkondensator 112 enthält in der oberen Metallisierungslage zwei kammförmige Elektroden, deren Zinken ineinander greifen. Von einer Längselektrode 118 zweigen bspw. vier Querelektroden 120 bis 126 ab, die in einem gleichbleibenden Rastermaß aufgereiht sind. An einer der Längselektrode 118 gegenüberliegenden Längselektrode 128 sind quer zur Längselektrode 128 genau so viele Querelektroden 130 bis 136 wie an der Längselektrode 118, d.h. vier Querelektroden 130 bis 136, angeordnet, die sich in die Zwischenräume zwischen den Querelektroden 120 bis 126 erstrecken. Damit wird zwischen den Querelektroden 120 bis 126 und 130 bis 136 ein mäanderförmig verlaufender Zwischenraum gebildet, der von einem Dielektrikum gefüllt ist. Die Länge des Mäanders des Hauptkondensators 112 sei wiederum La.

Die abtrennbaren Kondensatoren bzw. die zuschaltbaren Kondensatoren sind wie der Hauptkondensator 112 aufgebaut, enthalten jedoch kürzere Längselektroden 140, 142, 144 bzw. 146, von denen jeweils bspw. nur zwei Querelektroden 150 bis 160 abzweigen.

Zwischen der Längselektrode 118 und der Längselektrode 142 des Kondensators 114 liegt ein Bereich 162, zu dem eine Aussparung 164 von der Oberfläche des integrierten Schaltkreises führt. Zwischen der Längselektrode 128 und der Längselektrode 140 des Kondensators 114 liegt ein Bereich 166, zu dem eine weitere Aussparung 168 führt. Durch die Aussparungen 164 und 168 hindurch kann mit Hilfe eines Laserstrahls eine Unterbrechung zwischen den Längselektroden 118 und 142 bzw. den Längselektroden 128 und 140 in dem Bereich 162 bzw. 166 erzeugt werden. Dadurch lassen sich sämtliche abschaltbare Kondensatoren 114 vom Hauptkondensator 112 abtrennen. Zwischen den weiteren abschaltbaren Kondensatoren befinden sich weitere Bereiche 170 und 172, zu denen Aussparungen 174 und 176 führen, so dass auch an anderen Stellen abgetrennt werden kann.

Zwischen der Längselektrode 118 und der Längselektrode 146 des Korrektur-Kondensators 116 befindet sich ein Verknüpfungsbereich 180. Zwischen der Längselektrode 128 und der Längselektrode 144 des Kondensators 116 befindet sich ein Verknüpfungsbereich 182. Zum Verknüpfungsbereich 140 bzw. zum Verknüpfungsbereich 182 führt eine Aussparung 184 bzw. 186. Durch die Aussparungen 184 bzw. 186 lassen sich die Verknüpfungsbereiche 180 und 182 mit Hilfe eines Laserstrahls lokal erhitzen. Beim lokalen Erhitzen wird eine Verbindung zwischen der Längselektrode 118 und der Längselektrode 146 bzw. zwischen der Längselektrode 128 und der Längselektrode 144 erzeugt. Mit Hilfe weiterer Verknüpfungsbereiche 190, 192, zu denen Aussparungen 194 bzw. 196 führen, lassen sich elektrisch leitende Verbindungen zu weiteren zuschaltbaren Kondensatoren 116 herstellen.

Der Mäander des Hauptkondensators 112 hat eine Länge La, die größer ist als eine Länge Lb eines Mäanders des abtrennbaren Kondensators 114 bzw. eine Länge Lc eines Mäanders des zuschaltbaren Kondensators 116. Damit ist eine Kapazität C(0) des Hauptkondensators 112 größer als eine Kapazität Cm(I) des abtrennbaren Kondensators 114. Weitere Kapazitäten Cm(1) bis Cm(I-1) von weiteren abtrennbaren Kondensatoren sind gleich der Kapazität Cm(I). Eine Kapazität Cp(1) des zuschaltbaren Kondensators 116 ist gleich der Kapazität Cm(1). Kapazitäten Cp(2) bis Cp(N) der weiteren abtrennbaren Kondensatoren 116 sind gleich der Kapazität Cp(1).

Die Korrektur der Kapazität der Schaltungsanordnung 110 wird unten an Hand der Figur 5 näher erläutert.

Bei einem anderen Ausführungsbeispiel gibt es Aussparungen, die in unterschiedliche Metallisierungslagen führen, bspw. zu Verbindungs- oder Unterbrechungsmöglichkeiten, die versetzt zu darüber oder darunter liegenden Verbindungs- oder Unterbrechungsmöglichkeiten angeordnet sind. Bei einem alternativen Ausführungsbeispiel werden Verknüpfungsbereiche bzw. Bereiche für Unterbrechungen in einer oberen Metallisierungslage angeordnet, obwohl sie auch Elektroden betreffen, die in unteren Metallisierungslagen angeordnet sind. Weiterhin können die Kapazitäten Cm(1) bis Cm(I) bzw. Cp(1) bis Cp(N) der Kondensatoranordnung 110 voneinander verschiedene Kapazitäten haben.

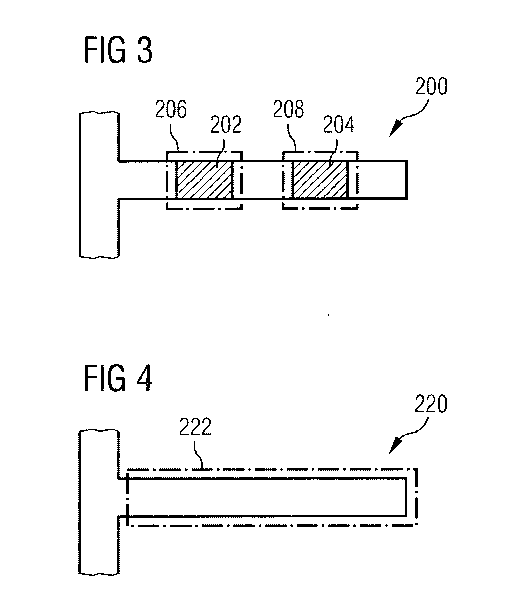

Figur 3 zeigt eine Querelektrode 200 eines Gitterkondensators. Die Querelektrode 200 hat bei etwa einem Drittel ihrer Länge einen Bereich 202 und bei etwa zwei Dritteln ihrer Länge einen Bereich 204. Zum Bereich 202 führt eine Aussparung 206. Zum Bereich 204 führt eine Aussparung 208. Bei der Korrektur der Kapazität des Gitterkondensators, zu dem die Querelektrode 200 gehört, wird entweder eine Unterbrechung im Bereich 202 oder eine Unterbrechung im Bereich 204 erzeugt. Wird die Unterbrechung im Bereich 202 erzeugt, so ist nur noch etwa ein Drittel der Querelektrode 200 schaltungstechnisch wirksam. Wird dagegen eine Unterbrechung im Bereich 204 erzeugt, so sind etwa noch zwei Drittel der Querelektrode 200 schaltungstechnisch wirksam. Durch die Auswahl eines Bereiches 202 bzw. 204 lassen sich Korrekturen der Kapazität des Gitterkondensators im Promille-Bereich ausführen.

Die Länge der Querelektrode 200 beträgt beispielsweise zehn Mikrometer. Die Breite liegt bspw. bei 0,5 Mikrometer, so dass ein Durchtrennen mit einem Laserstrahl problemlos möglich ist.

Figur 4 zeigt eine Querelektrode 220, zu der eine Aussparung 222 führt. Die Aussparung 222 erstreckt sich in etwa über die gesamte Länge der Querelektrode 220. Dadurch ist es möglich, die Querelektrode 220 an einer beliebigen Stelle zu unterbrechen. Mit anderen Worten lassen sich die Unterbrechungspunkte kontinuierlich entlang der Längsachse der Querelektrode 220 setzen.

Bei anderen Ausführungsbeispielen von Querelektroden 200 und 220 werden an Stelle oder in Kombination mit den zur Unterbrechung dienenden Bereichen Verknüpfungsbereiche verwendet. Die Unterbrechungsbereiche bzw. die Verknüpfungsbereiche werden entweder an einer Querelektrode eines Gitterkondensators oder an mehreren Querelektroden des Gitterkondensators angeordnet.

Figur 5 zeigt Verfahrensschritte zum Korrigieren der Kapazität einer integrierten Kondensatoranordnung, z.B. nach Figur 1, 2, 3 oder 4. Im Vorfeld des Verfahrens wird in einem Entwurfs- und Simulations-Stadium die Streuung der Kapazität der integrierten Schaltungsanordnung um eine Sollkapazität herum ermittelt, beispielsweise empirisch oder aufgrund von Simulationsläufen, siehe Verfahrensschritt 300. Abhängig von den Kapazitätsstreuungen werden Korrekturmöglichkeiten vorgesehen, siehe Verfahrensschritt 302. Die Korrekturmöglichkeiten sind beispielsweise abtrennbare Kondensatoren, zuschaltbare Kondensatoren, abtrennbare Kondensatorbereiche und/oder zuschaltbare Kondensatorbereiche. Die Korrekturmöglichkeiten werden im Verfahrensschritt 302 unter Berücksichtigung der zu erwartenden Kapazitätsstreuung so vorgegeben, dass im Hinblick auf die gesamte Fertigung möglichst wenig Unterbrechungen und Verknüpfungen durch Erhitzen mit dem Laserstrahl hergestellt werden müssen.

Das eigentliche Korrekturverfahren beginnt in einem Verfahrensschritt 304, an den sich die Prozessierung eines Wafers anschließt, siehe Verfahrensschritt 306. Beispielsweise werden in einem Halbleitermaterial des Wafers Transistoren erzeugt. Danach werden Metallisierungslagen aufgebracht, wobei auch Kondensatoren erzeugt werden.

In einem Verfahrensschritt 308 wird über eine Messung die Ist-Kapazität einer integrierten Kondensatoranordnung erfasst, d.h. insbesondere die Kapazität des Hauptkondensators 12, 112 zusammen mit den Kapazitäten der abtrennbaren Kondensatoren 14, 114.

In einem folgenden Verfahrensschritt 310 wird die Ist-Kapazität mit der Soll-Kapazität verglichen. Ist die Ist-Kapazität kleiner oder größer als die Soll-Kapazität, insbesondere kleiner oder größer als ein vorgegebener Toleranzbereich, so folgt unmittelbar nach dem Verfahrensschritt 310 ein Verfahrensschritt 312. Im Verfahrensschritt 312 wird geprüft, ob die Ist-Kapazität größer als die Soll-Kapazität ist. Ist dies der Fall, so folgt nach dem Verfahrensschritt 312 ein Verfahrensschritt 314, in welchem mit Hilfe eines Laserstrahls Unterbrechungen in der integrierten Kondensatoranordnung erzeugt werden, wobei abtrennbare Kondensatoren 14, 114 vom Hauptkondensator 12, 112 abgetrennt werden. Die Kapazität der Kondensatoranordnung wird kleiner. Auch ein Abtrennen eines Elektrodenabschnitts von einer Querelektrode wird alternativ durchgeführt.

Wird dagegen im Verfahrensschritt 312 festgestellt, dass die Ist-Kapazität kleiner als die Soll-Kapazität ist, so folgt nach dem Verfahrensschritt 312 unmittelbar ein Verfahrensschritt 316. Im Verfahrensschritt 316 werden Verknüpfungsbereiche mit Hilfe eines Laserstrahls erhitzt. Dadurch werden zuschaltbare Kondensatoren 16, 116 zum Hauptkondensator 12, 112 bzw. zu einem Hauptbereich hinzugeschaltet. Somit vergrößert sich die Kapazität der Kondensatoranordnung in Richtung der Soll-Kapazität. Auch ein Zuschalten von Elektrodenabschnitten einer Querelektrode wird alternativ durchgeführt.

Wird im Verfahrensschritt 310 dagegen festgestellt, dass Ist-Kapazität und Soll-Kapazität übereinstimmen, so folgt unmittelbar ein Verfahrensschritt 318. Der Verfahrensschritt 318 wird auch nach dem Verfahrensschritt 314 oder dem Verfahrensschritt 316 ausgeführt. Im Verfahrensschritt 318 wird der Wafer weiter prozessiert. Dabei wird unter anderem eine Passivierungsschicht aufgebracht, welche die Aussparungen für den Laserstrahl verschließt.

In einem weiteren Verfahrensschritt 320 werden die auf dem Wafer angeordneten Schaltkreise vereinzelt und in Gehäuse eingegossen. Das Verfahren wird in einem Verfahrensschritt 322 beendet.

Bei einem anderen Ausführungsbeispiel wird die Korrektur nach dem Vereinzeln der Schaltkreise durchgeführt. Beispielsweise werden Stromstöße zum Erhitzen der Unterbrechungsbereiche bzw. der Verknüpfungsbereiche genutzt. Auch die Abfragen in den Verfahrensschritten 310 und 312 lassen sich anders formulieren.

Durch das angegebene Verfahren ergeben sich die folgenden Vorteile:

- die durch Geometrie- oder Prozessschwankungen verursachten Streuungen der Kapazitäten lassen sich auf einfache Weise nachträglich korrigieren. Damit kann die Ausbeute bzw. die Performance erhöht werden.
- Die Möglichkeit der nachträglichen Korrektur erlaubt darüber hinaus ein für den jeweiligen integrierten Schaltkreis individuelles Anpassen der Kapazität. Damit kann eine speziell auf andere Schaltungselemente abgestimmte Kapazitätsanpassung vorgenommen werden, z.B. zur optimalen Arbeitspunkteinstellung. Dies ist insbesondere dann vorteilhaft, wenn die anderen Schaltungselemente nicht mehr korrigierbar sind.

Durch Abtrennen bzw. Hinzufügen von Bereichen des Kondensators mit Hilfe von sogenannten Fuses bzw. Antifuses lässt sich also der Einfluss von Prozess- und Geometrieschwankungen auf die Parameter des Hauptkondensators, insbesondere auf die Kapazität und auf den Widerstand (und damit auf die RC-Konstante), nachträglich korrigieren.

Bei der Korrektur in den Verfahrensschritten 310 bis 316 lässt sich die folgende Formel verwenden:

$$Ckorr = C(0) - Summe(i=1 \text{ bis } I1 \text{ über } Cm(i))$$
$$+ Summe(n=1 \text{ bis } N1 \text{ über } Cp(n)),$$

wobei die verwendeten Größen bis auf die Größen I1 und N1 bereits oben erläutert worden sind. Der Index i bei Summierung über die Kapazitäten Cm muss alle abgetrennten Kondensatoren berücksichtigen, wobei I1 den letzten abgetrennten Kondensator bezeichnet. Der Index bei der Summierung über die Kapazitäten Cp muss alle zugeschalteten Kapazitäten berücksichtigen, wobei N1 den letzten zugeschalteten Kondensator bezeichnet. Weiterhin ist zu beachten, das entweder Kondensatoren zugeschaltet oder abgetrennt werden.

Sind die Kapazitäten Cm bzw. Cp gleich, so kann an Stelle der Summe mit einem Faktor multipliziert werden, der die Anzahl der abgetrennten bzw. der zugeschalteten Kondensatoren angibt.

Beim Ermitteln der Kapazitätsstreuung lassen sich die folgenden für einen Plattenkondensator geltenden Zusammenhänge nutzen:

$$C = \varepsilon 0 \cdot \varepsilon r \cdot Aeff / Deff,$$

wobei $\varepsilon 0$, $\varepsilon r$ die entsprechenden Dielektrizitätskonstanten, Aeff die effektive Elektrodenfläche und Deff den effektiven Elektrodenabstand darstellen. Eine Schwankung der Fläche $\Delta$Aeff bzw. des Abstandes $\Delta$Deff bedingt dann eine Änderung der Kapazität von:

$$\Delta C = \Delta Aeff / Aeff \text{ bzw. } \Delta C = \Delta Deff / Deff.$$

In erster Näherung entspricht die effektive Elektrodenfläche bei:

  a) den MIM-Kondensatoren: der überlappenden Fläche der Elektroden,
  b) den Sandwich-Kondensatoren: der Fläche der Metallelektroden,
  c) den Gitterkondensatoren: der Seitenfläche der Leiterbahnen, die sich aus der Länge L und der Dicke T ergibt.

Der effektive Elektrodenabstand entspricht bei:

  a) den MIM-Kondensatoren: der Dicke des Dielektrikums, das sich vom Dielektrikum zwischen den Metallisierungslagen unterscheidet,
  b) den Sandwich-Kondensatoren: der Dicke des Intermetall-Dielektrikums,
  c) den Gitterkondensatoren: der Dicke des Intrametall-Dielektrikums, d.h. des sogenannten Spacings.

Ein anderer Einflussfaktor ist bspw. bei Gitterkondensatoren die Ausbildung von Ecken. Diese Einflussgrößen lassen sich zumindest messtechnisch erfassen und dann berücksichtigen.
Die Schwankungen der Kapazitäten können folgende prozessbedingte Ursachen haben:

  a) MIM-Kondensatoren: Schwankungen in der Dicke des MIM-Dielektrikums, z.B. durch inhomogene Abscheideraten über dem Wafer oder unterschiedliche Rauhigkeit der unteren Elektrode.
  b) Sandwich-Kondensatoren: Schwankungen der Dicke des Intermetall-Dielektrikums, z.B. Dickeschwankungen durch Polier-Inhomogenitäten oder Schwankungen der Ätztiefe über dem Wafer.
  c) Gitterkondensatoren: Schwankungen des Elektrodenabstandes durch Variation der Dicke des Intrametall- Dielektrikums bedingt z.B. durch Lithografieschwankungen, RIE-Strukturierung (Reactive Ion Etching) bei Verwendung von Aluminium oder durch Grabenätzen bei Verwendung von Kupfer. Weitere Ursachen sind Schwankungen der Elektrodenfläche durch Variation der Leitbahndicke bzw. durch CMP-Schwankungen (Chemical Mechanical Polishing), sogenanntes Dishing, nicht rechtwinkliges Trenchprofil bei Verwendung von Kupfer oder durch inhomogene Abscheideraten.

Bei MIM-Kondensatoren und Sandwich-Kondensatoren wird die Kapazität durch direktes Abtrennen bzw. Zuschalten von M Flächensegmenten der Elektrode korrigiert:

$$A = A0 \pm Summe(i=1 \text{ bis } M \text{ über } Ai),$$

dabei sind A0 die nicht mehr korrigierbare Elektrodengrundfläche, M eine natürliche Zahl und Ai die abtrennbaren bzw. zuschaltbaren diskreten Flächenelemente. Für die abtrennbaren Flächenelemente gilt das Minuszeichen. Für die zuschaltbaren Flächenelemente gilt das Pluszeichen.
Bei den Gitterkondensatoren wird die Elektrodenfläche A über die Länge L der Leitbahn eingestellt: A = L . T, wobei T die mittlere Leitbahndicke innerhalb der Kondensatorstruktur ist. Durch Abtrennen bzw. Zuschalten von M Leitbahnsegmenten, z.B. n diskreten Segmenten Li der Elektrode wird korrigiert:

$$L = L0 \pm \text{Summe}(i=1 \text{ bis } M \text{ über } Li),$$

wobei L0 die nicht mehr korrigierbare Elektrodengrundlänge, M eine natürliche Zahl und Li die abtrennbaren bzw. zuschaltbaren diskreten Leitbahnsegmente bezeichnen. Für die abtrennbaren Leitbahnsegmente gilt das Minuszeichen. Für die zuschaltbaren Leitbahnsegmente gilt das Pluszeichen.

**Patentansprüche**

1. Satz integrierter Kondensatoren (110),
   mit mindestens zwei integrierten Kondensatoren, die gemäß gleichen geometrischen Entwürfen hergestellt sind und jeweils mehrere Querelektroden enthalten, die einen schaltungstechnisch wirksamen Hauptteil des Kondensators bilden,
   mit mindestens zwei (220) an gleichen Positionen in den Kondensatoren (110) angeordneten Korrekturquerelektroden, die unterschiedlich lange schaltungstechnisch wirksame Längen haben,
   wobei die schaltungstechnisch wirksame Länge einer Korrekturquerelektrode (200) nach der Herstellung des Hauptteils durch eine elektrisch isolierende Unterbrechung (206) und/oder durch Verdampfen eines Teils der Korrekturquerelektrode verkürzt oder durch Herstellen einer elektrisch leitfähigen Verbindung verlängert worden ist,
   wobei die Kondensatoren Gitterkondensatoren (110) sind, mit kammförmigen Elektroden, deren Zinken ineinander greifen.

2. Gitterkondensatoren (110) nach Anspruch 1, **dadurch gekennzeichnet, dass** in einem die Korrekturquerelektrode bedeckenden Material mindestens eine Aussparung (206, 208; 222) angeordnet ist, die zu der Korrekturquerelektrode und/oder zu einem Bereich führt, an dem die Korrekturquerelektrode vor dem Verdampfen angeordnet war, und/oder dass die Aussparung (206, 208; 222) mit einem passivierenden Material gefüllt ist.

3. Gitterkondensatoren (110) nach Anspruch 2, **dadurch gekennzeichnet, dass** zu einer Korrekturquerelektrode (200) mehrere Aussparungen (206, 208) führen,
   oder dass zu einer Korrekturquerelektrode (220) eine Aussparung führt, die im Wesentlichen den gesamten Bereich der ursprünglichen Korrekturquerelektrode überdeckt.

4. Verfahren zum Herstellen eines Satzes integrierter Kondensatoren (110),
   bei dem mindestens zwei integrierte Kondensatoren gemäß gleichen geometrischen Entwürfen hergestellt werden und jeweils mit mehrere Querelektroden versehen werden, die einen schaltungstechnisch wirksamen Hauptteil des Kondensators bilden, bei dem mindestens zwei (220) an gleichen Positionen in den Kondensatoren (110) angeordnete Korrekturquerelektroden ausgebildet werden, die unterschiedlich lange schaltungstechnisch wirksame Längen haben,
   und bei dem die schaltungstechnisch wirksame Länge einer Korrekturquerelektrode (200) nach der Herstellung des Hauptteils durch eine elektrisch isolierende Unterbrechung (206)
   und/oder durch Verdampfen eines Teils der Korrekturquerelektrode verkürzt oder durch Herstellen einer elektrisch leitfähigen Verbindung verlängert wird,
   wobei die Kondensatoren Gitterkondensatoren (110) sind, mit kammförmigen Elektroden, deren Zinken ineinander greifen.

5. Verfahren nach Anspruch 4, **dadurch gekennzeichnet, dass** in einem die Korrekturquerelektrode bedeckenden Material mindestens eine Aussparung (206, 208; 222) angeordnet wird, die zu der Korrekturquerelektrode und/oder zu einem Bereich führt, an dem die Korrekturquerelektrode vor dem Verdampfen angeordnet worden ist, und/oder dass die Aussparung (206, 208; 222) mit einem passivierenden Material gefüllt wird.

6. Verfahren nach Anspruch 5, **dadurch gekennzeichnet, dass** zu einer Korrekturquerelektrode (200) mehrere Aussparungen (206, 208) geführt werden,
   oder dass zu einer Korrekturquerelektrode (220) eine Aussparung geführt wird, die im wesentlichen den gesamten Bereich der ursprünglichen Korrekturquerelektrode überdeckt.

**EP 1 587 145 B1**

**Claims**

1. Set of integrated capacitors (110),
having at least two integrated capacitors which are produced in accordance with identical geometrical designs and each contain a plurality of transverse electrodes forming a circuitry-effective main part of the capacitor,
having at least two (220) correction transverse electrodes which are arranged at identical positions in the capacitors (110) and which have circuitry-effective lengths of different magnitudes,
wherein the circuitry-effective length of a correction transverse electrode (200), after the production of the main part, has been shortened by an electrically insulating interruption (206) and/or by vaporization of part of the correction transverse electrode or has been lengthened by production of an electrically conductive connection,
wherein the capacitors are grid capacitors (110), having comb-shaped electrodes whose tines intermesh.

2. Grid capacitors (110) according to Claim 1, **characterized in that,** in a material covering the correction transverse electrode, there is arranged at least one cutout (206, 208; 222) leading to the correction transverse electrode and/or to a region at which the correction transverse electrode was arranged prior to the vaporization,
and/or **in that** the cutout (206, 208; 222) is filled with a passivating material.

3. Grid capacitors (110) according to Claim 2, **characterized in that** a plurality of cutouts (206, 208) lead to a correction transverse electrode (200),
or **in that** one cutout which essentially covers the entire region of the original correction transverse electrode leads to a correction transverse electrode (220).

4. Method for producing a set of integrated capacitors (110),
in which at least two integrated capacitors are produced in accordance with identical geometrical designs and are provided in each case with a plurality of transverse electrodes forming a circuitry-effective main part of the capacitor,
in which at least two (220) correction transverse electrodes arranged at identical positions in the capacitors (110) are formed, which electrodes have circuitry-effective lengths of different magnitudes,
and in which the circuitry-effective length of a correction transverse electrode (200), after the production of the main part, is shortened by an electrically insulating interruption (206) and/or by vaporization of part of the correction transverse electrode or is lengthened by production of an electrically conductive connection,
wherein the capacitors are grid capacitors (110), having comb-shaped electrodes whose tines intermesh.

5. Method according to Claim 4, **characterized in that,** in a material covering the correction transverse electrode, there is arranged at least one cutout (206, 208; 222) leading to the correction transverse electrode and/or to a region at which the correction transverse electrode has been arranged prior to the vaporization,
and/or **in that** the cutout (206, 208; 222) is filled with a passivating material.

6. Method according to Claim 5, **characterized in that** a plurality of cutouts (206, 208) are led to a correction transverse electrode (200),
or **in that** a cutout which essentially covers the entire region of the original correction transverse electrode is led to a correction transverse electrode (220).

**Revendications**

1. Jeu de condensateurs (110) intégré,
comprenant au moins deux condensateurs intégrés qui sont fabriqués suivant de mêmes plans géométriques et qui comportent respectivement plusieurs électrodes transversales formant une partie principale du condensateur efficace du point de vue de la technique des circuits,
comprenant au moins deux (220) électrodes transversales de correction, disposées en de mêmes positions dans les condensateurs (110) et ayant des longueurs efficaces différentes du point de vue de la technique des circuits,
dans lequel la longueur efficace du point de vue de la technique des circuits d'une électrode (200) transversale de correction est, après la fabrication de la partie principale, diminuée par une interruption (206) isolante du point de vue électrique et/ou par évaporation d'une partie de l'électrode transversale de correction ou est augmentée par une production d'une liaison conductrice d'électricité et,
les condensateurs étant des condensateurs (110) à grille ayant des électrodes en forme de peigne, dont les dents s'interpénètrent.

**2.** Condensateurs (110) à grille suivant la revendication 1, **caractérisés en ce que** dans un matériau recouvrant l'électrode transversale de correction est ménagé au moins un évidement (206, 208 ; 222) qui mène à l'électrode transversale de correction et/ou à une partie sur laquelle l'électrode transversale de correction était disposée avant l'évaporation et/ou **en ce que** l'évidement (206, 208 ; 222) est rempli d'un matériau passivant.

**3.** Condensateurs (110) à grille suivant la revendication 2, **caractérisés en ce que** plusieurs évidements (206, 208) mènent à une électrode (220) transversale de correction et,

ou **en ce que** un évidement, qui recouvre sensiblement toute la partie de l'électrode transversale de correction d'origine, mène a une électrode (220) transversale de correction.

**4.** Procédé de production d'un jeu de condensateurs (110) intégré,

dans lequel on fabrique au moins deux condensateurs intégrés suivant les mêmes plans géométriques et on les munit respectivement de plusieurs électrodes transversales qui forment une partie principale du condensateur efficace du point de vue de la technique des circuits,

dans lequel on forme au moins deux électrodes (220) transversales de correction disposées en de mêmes positions dans des électrodes qui sont disposées dans les condensateurs (110) et qui ont des longueurs efficaces différentes du point de vue de la technique des circuits,

et dans lequel on diminue la longueur efficace du point de vue de la technique des circuits d'une électrode (200) transversale de correction après la fabrication de la partie principale par une interruption (206) isolante du point de vue électrique et/ou par évaporation d'une partie de l'électrode transversale de correction ou on l'augmente par production d'une liaison conductrice de l'électricité,

les condensateurs étant des condensateurs (110) à grille ayant des électrodes en forme de peigne, dont les dents s'interpénètrent.

**5.** Procédé suivant la revendications 4, **caractérisé en ce que** l'on ménage dans un matériau recouvrant l'électrode transversale de correction au moins un évidement (206, 208 ; 222) qui mène à l'électrode transversale de correction et/ou à une partie sur laquelle l'électrode transversale de correction a été disposée avant l'évaporation,

et/ou **en ce qu'**on remplit l'évidement (206, 208 ; 222) d'un matériau passivant.

**6.** Procédé suivant la revendication 5, **caractérisé en ce que** plusieurs évidements (206, 208) mènent à une électrode (220) transversale de correction,

ou **en ce que** l'évidement qui recouvre sensiblement toute la partie de l'électrode transversale de correction d'origine, mène à une électrode (220) transversale de correction.

FIG 1

FIG 2

## FIG 3

206  202  208  204  200

## FIG 4

222  220

FIG 5

Ermitteln der
Kapazitätsstreuung
um Sollkapazität — 300

z.B. empirisch

} Entwurf und Simulation

Korrekturmöglichkeiten
vorsehen — 302

Start — 304

Scheibenprozessierung — 306

Erfassen der
Ist-Kapazität — 308

Ist = Soll? —— nein

310

ja

312

ja — Ist > Soll? — nein

314 — Unterbrechung

Verknüpfung — 316

Passivieren — 318

Vereinzeln — 320

Ende — 322

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1111694 A2
- US 3766308 A
- US 5659182 A